# FASCICULE DE BREVET EUROPEEN

(11) **EP 0 302 820 B1**
(45) Date de publication et mention de la délivrance du brevet: **10.02.1993**
(21) Numéro de dépôt: 88810448.6
(22) Date de dépôt: 30.06.1988
(51) Int. Cl.: H01L 31/115, G01T 1/29

(54) **Détecteur de particules ionisantes**
Detektor für ionisierende Teilchen
Detector of ionizing particles

(30) Priorité: 17.07.1987 FR 8710118
(43) Date de publication de la demande: 08.02.1989
(73) Titulaire: CENTRE SUISSE D'ELECTRONIQUE ET DE MICROTECHNIQUE S.A., CH-2000 Neuchâtel 7 (CH)
(72) Inventeur: Guye, Raymond, CH-2013 Colombier NE (CH); Vuilleumier, Raymond, CH-2052 Fontainemelon NE (CH)
(74) Mandataire: Brulliard, Joel

(56) Documents cités:
- WO-A-85/04987
- NUCLEAR INSTRUMENTS AND METHODS, vol. 205, no. 1/2, janvier 1983, pages 99-105, North-Holland Publ. Co., Amsterdam, NL; B. HYAMS et al.: "A silicon counter telescope to study short-lived particles in high-energy hadronic interactions"

## Description

La présente invention se rapporte aux détecteurs de particules ionisantes en général et concerne plus particulièrement un détecteur de type diode réalisé dans un matériau semiconducteur.

De tels détecteurs ont déjà été largement utilisés pour la détection ou la spectroscopie de particules ionisantes telles que: électrons, protons, particules α, rayons X ou γ, etc. Ils constituent donc des outils extrêmement précieux tant pour la recherche dans des domaines aussi divers que la physique, l'astrophysique ou le nucléaire que pour des analyses dans les techniques chimiques ou médicales. Ces détecteurs consistent en un matériau semiconducteur faiblement dopé (généralement en silicium) dans lequel est réalisée une diode entre deux électrodes conductrices. Une tension externe est appliquée aux électrodes de manière à polariser la diode en inverse et à créer dans le semiconducteur une zone de déplétion qui constitue la zone sensible du détecteur. Dans les applications où une résolution spatiale selon une direction est requise, l'une des électrodes est divisée en une pluralité d'électrodes parallèles qui assurent la discrimination spatiale voulue. L'utilisation combinée de plusieurs détecteurs de ce type permet une résolution dans un espace à plusieurs dimensions. Cette dernière n'est cependant possible que pour des particules d'énergie assez grande pour qu'elles traversent ces détecteurs avec une très faible perte d'énergie.

Les caractéristiques générales requises de ces détecteurs sont l'efficacité, c'est-à-dire l'obtention d'une impulsion électrique suffisante pour chaque particule traversant le détecteur et la rapidité de détection. Ces caractéristiques sont liées à un certain nombre de paramètres qui sont soit spécifiques du matériau utilisé ou dépendant de la structure ou des procédés de fabrication utilisés. On peut citer, parmi les propriétés requises les plus importantes: la faible concentration de dopage du substrat, la tension élevée de polarisation, le faible courant de fuite, le faible taux de charges trappées et la stabilité des performances en fonction du temps et des irradiations.

Les détecteurs connus à ce jour soit ne présentent pas la totalité des propriétés requises, soit ont une structure complexe qui rend leur coût de fabrication élevé.

Aussi un objet de la présente invention est un détecteur de particules ionisantes ayant des performances améliorées par rapport aux détecteurs de l'art antérieur.

Un autre objet de l'invention est un détecteur dont les performances électriques restent stables pendant une longue période d'utilisation sous irradiation.

Ces objets sont réalisés au moyen des charactéristiques de la revendication 1. Le détecteur comporte en plus de la jonction conventionnelle qui, polarisée en inverse, engendre une zone de déplétion constituant la partie sensible du détecteur, une zone dopée de type n servant de limite à la zone de déplétion.

Cet agencement particulier rend la structure selon l'invention moins critique que certains détecteurs connus tout en assurant les performances requises telles que l'efficacité et la tenue aux radiations.

D'autres objets, caractéristiques et avantages de la présente invention apparaîtront plus clairement à la lecture de la description suivante d'un exemple de réalisation, ladite description étant faite à titre purement illustratif et en relation avec les dessins joints dans lesquels:
la figure 1 montre un exemple de réalisation connu de l'art antérieur;
la figure 2 montre un autre exemple de réalisation connu de l'art antérieur;
la figure 3 montre un exemple de réalisation selon les caractéristiques de la présente invention; et
les figures 4.a à 4.e montrent différentes étapes de fabrication du dispositif de la figure 3.

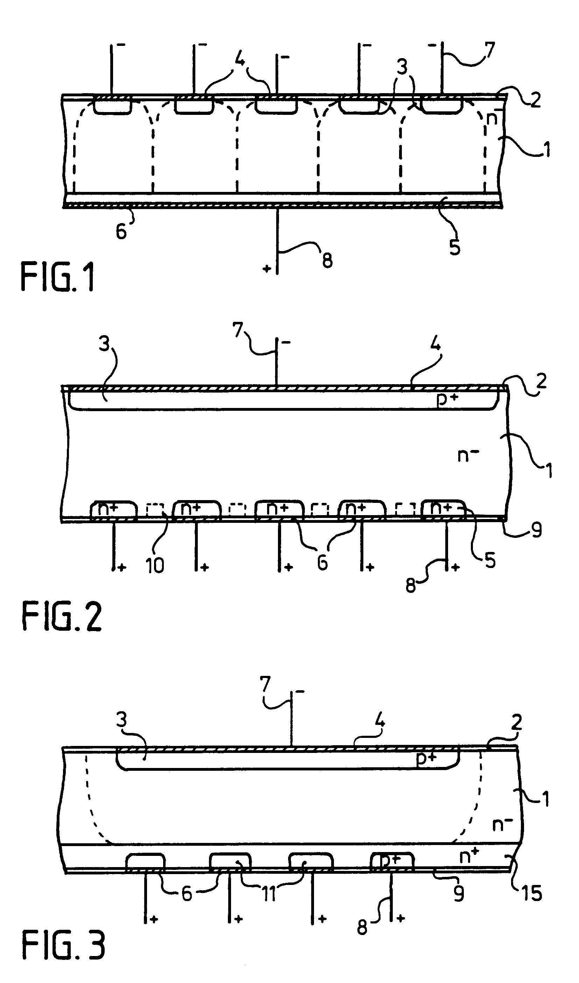

L'exemple de réalisation montré à la figure 1, représente un détecteur connu de l'art antérieur. Il est réalisé à partir d'une plaquette de silicium monocristallin 1 très faiblement dopé de type n. Une résistivité typique de 4 x 10³ Ω.cm permet l'obtention de zones de déplétion importantes. Une série de bandes parallèles et équidistantes, constituées par des zones 3 fortement dopées de type p⁺, forment avec le substrat 1 de type n autant de diodes détectrices. Les zones 3 de type p⁺ sont reliées à la borne négative d'une source de polarisation externe (non représentée) par l'intermédiaire de contacts en aluminium 4 et de connexions 7. Une couche de passivation 2 en oxyde de silicium ou autre diélectrique recouvre les zones non protégées par la métallisation. Le substrat 1 est également relié à la borne positive de la source de polarisation externe mentionnée ci-dessus par l'intermédiaire d'une zone de diffusion 5, de type n⁺, plus fortement dopée que le substrat, d'une métallisation 6 et d'une connexion 8.

En fonctionnement, chaque diode constituée par une zone p⁺ et le substrat n⁻ est polarisée en inverse à une tension suffisante (typiquement de l'ordre de 100 volts), pour que la zone de déplétion créée s'étende dans toute l'épaisseur du substrat. Lorsqu'une particule ionisante traverse le détecteur, elle engendre des paires électron-trou qui sont alors collectées par les électrodes (4,6) donnant naissance à un courant qui peut être détecté par un circuit approprié. La résolution spatiale d'un tel détecteur est fonction du nombre de bandes (3,4) et du pas de ces bandes. Un détecteur comportant une série de bandes avec un pas de 20 micromètres est présenté dans l'article de B. Hyams et al. ,NUCLEAR INSTRUMENTS & METHODS IN PHYSICS RECHERCHE, vol. 205, no. 1/2, janvier 1983, p.99-105.

Bien qu'ayant l'avantage d'un faible courant de fuite par jonction et d'un bon découplage électrique d'une diode à l'autre, le dé-tecteur de la figure 1 présente l'inconvénient d'une mauvaise tenue aux radiations. Cette mauvaise tenue aux radiations signifie une dégradation des performances du détecteur (en particulier augmentation du courant de fuite et diminution de la tension de charge des jonctions) et, par suite, une limitation de sa durée de vie. Cette mauvaise tenue aux radiations est principalement due aux fortes courbures des jonctions, entraînant des phénomènes de claquage, au rapport élevé du périmètre à la surface de chaque jonction, ainsi qu'au trappage des charges dans l'oxyde 2 ou à l'interface entre cet oxyde 2 et le silicium 1.

En vue d'améliorer la tenue aux radiations, il a été proposé une structure telle que représentée à la figure 2, dans laquelle les éléments analogues à ceux de la figure 1 portent les mêmes références. La pluralité de zones p⁺ 3 de la figure 1 a été remplacée par une seule zone p⁺ 3 dans la figure 2. La résolution spatiale est alors assurée par la pluralité de zones n⁺ 5, connectées aux électrodes 8. Il est aisé de voir que le problème lié à la forte courbure des jonctions dans le cas de la figure 1, se trouve en partie résolu dans la structure de la figure 2. Toutefois, afin d'assurer un bon découplage électrique entre les zones 5 et, par suite, une bonne résolution spatiale, il est nécessaire que la zone de déplétion, créée par la polarisation inverse de la jonction p-n, soit totale. Cette condition est cependant critique car, si la zone de déplétion atteint l'interface entre le silicium 1 et la couche d'oxyde 9, cela entraîne une augmentation du courant de fuite de la jonction; ce qui se traduit par une perte de sensibilité du détecteur. Un autre paramètre qu'il est important de considérer dans l'exemple de la fig. 2 est le parallélisme des faces opposées du détecteur. En effet, si celles-ci ne sont pas strictement parallèles, il peut arriver que la zone de déplétion soit totale sur une partie de la plaquette et qu'elle ne soit pas totale sur une autre partie. Le même phénomène peut également exister du fait des inhomogénéités du dopage dans une plaquette qui engendrent localement une déplétion totale alors qu'elle n'est que partielle ailleurs. Il a, par ailleurs, été proposé d'insérer des zones dopées p⁺ 10 entre les zones n⁺ 5. Cette solution assure un bon découplage entre les zones 5 mais rend la structure du détecteur plus complexe. De plus, cette solution s'oppose à l'application qui consiste à utiliser le couplage capacitif existant entre des zones 5 adjacentes dans le but de diminuer le nombre de connexions 8 tout en conservant une bonne résolution spatiale. Enfin, elle constitue une limitation du nombre de bandes 5.

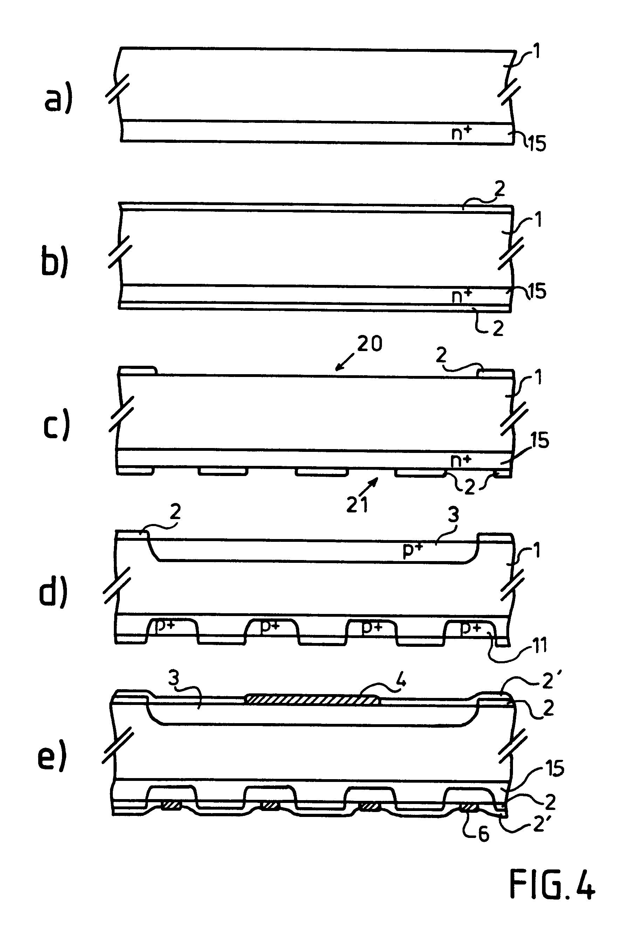

L'exemple de réalisation, représenté à la figure 3, permet d'exposer les différentes caractéristiques de l'invention et d'en souligner les avantages. Comme dans le cas de la figure 2, il est tiré avantage d'une zone implantée 3 unique et large de type p⁺ qui offre, vis-à-vis de la surface totale de jonction, de faibles zones de courbure. Selon l'invention, sur le côté opposé à la zone p⁺ de la plaquette sont réalisées des diodes p-n polarisées en direct. Ces diodes sont réalisées par une première implantation pour obtenir la zone dopée n⁺ 15, suivie d'une deuxième implantation pour obtenir les zones dopées p⁺ 11. La structure présentée à la figure 3, et dont le procédé de fabrication sera décrit ultérieurement en relation avec les figures 4.a à 4.e, ne présente pas la même criticité que la structure de la figure 2 quant à la profondeur de la zone de déplétion. En effet, la zone dopée n⁺ 15 constitue une limite d'arrêt de la zone de déplétion. Le défaut de parallélisme entre les faces est sans influence sur les caractéristiques de cette structure qui, par ailleurs, demeure également insensible aux charges trappées dans l'oxyde 9. Les autres avantages de cette structure sont: un faible courant de fuite; un bon découplage électrique entre les zones p⁺ 11 ainsi qu'un couplage capacitif élevé entre deux zones adjacentes; une bonne stabilité des caractéristiques électriques; et, de manière générale, une bonne tenue aux radiations. Par rapport à la structure connue de la figure 2 la structure de l'invention présente, par ailleurs, l'avantage de ne pas nécessiter de "garde" (zones dopées p⁺ 10 de la figure 2), ce qui permet d'une part de réaliser un grand nombre de zones de détection 11 et, d'autre part, de pouvoir tirer profit du couplage capacitif élevé entre les zones de détection 11 pour diminuer éventuellement le nombre de connexions externes sans perte en résolution spatiale.

Les figures 4.a à 4.e permettent de décrire brièvement le procédé de fabrication d'un détecteur selon l'invention. La plaquette 1 en silicium faiblement dopé (résistivité typique: 4 x 10³ Ω.cm) subit, sur une face, une implantation d'Arsenic (As) pour réaliser la zone 15 dopée n (fig. 4.a). Un oxyde de silicium (SiO₂) 2 est ensuite crû thermiquement ou déposé sur les deux faces de la plaquette (fig. 4.b). La figure 4.c montre les fenêtres 20 et 21, ouvertes dans les couches d'oxyde par photolithographie. Les zones p⁺, 3 et 11, sont ensuite réalisées par implantation de Bore à travers les fenêtres 20 et 21, respectivement (fig. 4.d). A l'issue de l'implantation de Bore, les deux faces du dispositif sont recouvertes d'une nouvelle couche d'oxyde (SiO₂), et/ou d'un autre diélectrique, déposé 2' à travers lequel sont ouvertes des fenêtres pour réaliser les contacts 4 et 6 à la zone p⁺ 3 et aux zones p⁺ 11, respectivement. La figure 4.e montre le dispositif après métallisation.

## Revendications

1. Détecteur de particules ionisantes comprenant, dans un substrat de silicium faiblement dopé (1) de type n, une première zone large de type p⁺ (3) plus fortement dopée que le substrat, s'étendant sur une partie de la première face dudit substrat et formant avec celui-ci une jonction de type p⁺-n et une pluralité de deuxièmes zones (11), d'étendue sensiblement plus faible que ladite première zone dopée et s'étendant longitudinalement sur une partie de la deuxième face dudit substrat opposée à ladite première face de manière à former des bandes équidistantes et parallèles entre elles, ladite première zone ainsi que chaque deuxième zone étant pourvue d'une électrode (7, 8); ledit détecteur étant caractérisé en ce qu'il comprend, en outre, une troisième zone (15) de même type n mais plus fortement dopée que le substrat et s'étendant sur toute la surface de ladite deuxième face; en ce que lesdites deuxièmes zones (11) sont réalisées dans ladite troisième zone et sont d'un type de dopage opposé à celui de ladite troisième zone; en ce que ladite jonction p⁺-n, formée par le substrat d'une part et ladite première zone d'autre part, est polarisée en inverse de manière que la zone de déplétion, engendrée en dessous de ladite jonction, atteigne ladite troisième zone et en ce que les diodes, formées par ladite troisième zone d'une part et lesdites deuxièmes zones d'autre part, sont polarisées en direct.

## Claims

1. An ionising radiation detector comprising, in a lightly doped n-type silicon substrate (1), a first wide p⁺-type area (3), more heavily doped than the substrate, extending over a part of the first face of the said substrate and forming with the latter a p⁺-n junction, and a plurality of second areas (11), substantially smaller in extent than the said first doped area and extending longitudinally over a part of the second face of the said substrate opposite the said first face so as to form strips equidistant from and parallel to each other, the said first area and each second area having an electrode (7, 8); the said detector being characterised in that it comprises in addition a third area (15), also n-type but more heavily doped than the substrate and extending over the entire surface of the said second face; in that the said second areas (11) are produced in the said third area and are of a doping type opposite to the said third area; in that the said p⁺-n junction, formed by the substrate on the one hand and the said first area on the other hand, is reversed-biased so that the depletion layer, generated below the said junction, reaches the said third area and in that the diodes, formed by the said third area on the one hand and the said second areas on the other hand, are forward-biased.

## Patentansprüche

1. Detektor für ionisierende Teilchen, umfassend, in einem schwach dotierten Substrat aus n-Silizium (1), eine erste breite Zone des Typs p⁺ (3), die stärker dotiert ist als das Substrat, welche sich über eine Partie der ersten Seite des Substrats erstreckt und mit diesem eine Sperrschicht vom Typ p⁺-n bildet, sowie eine Mehrzahl von zweiten Zonen (11), deren Ausdehnung sehr viel geringer ist als die der ersten dotierten Zone, und die sich in Längsrichtung auf einer Partie der zweiten Seite des Substrats gegenüber der ersten Seite derart erstrecken, daß Bänder gleichen Abstandes und parallel zueinander gebildet werden, wobei die erste Zone wie auch die zweite Zone mit einer Elektrode (7, 8) versehen sind, welcher Detektor dadurch gekennzeichnet ist, daß er ferner eine dritte Zone (15) vom gleichen n-Typ, jedoch stärker dotiert als das Substrat, umfaßt, die sich auf der gesamten Oberfläche der genannten zweiten Seite erstreckt, daß die zweiten Zonen (11) in der dritten Zone realisiert sind und von einem Dotierungstyp sind entgegengesetzt demjenigen der dritten Zone, daß die p⁺-n-Sperrschicht, gebildet von dem Substrat einerseits und der ersten Zone andererseits in Sperrichtung derart vorgespannt ist, daß die Verarmungszone, erzeugt unter der Sperrschicht, die dritte Zone erreicht, und daß die Dioden, gebildet von der dritten Zone einerseits und den zweiten Zonen andererseits, in Durchlaßrichtung vorgespannt sind.
